# EUROPEAN PATENT APPLICATION

(11) **EP 4 610 028 A1**
(43) Date of publication of application: **03.09.2025**
(21) Application number: 25158660.8
(22) Date of filing: 18.02.2025
(51) Int. Cl.: B29C 64/393, B22F 10/85, B33Y 10/00, B33Y 30/00, B33Y 50/02, G01N 21/01, G06F 30/20, G06N 20/00, G06T 7/00, G01B 11/00, G01N 21/88, G06N 3/08, G06V 10/00

(54) **ADJUSTING MANUFACTURING PARAMETERS USING ARTIFICIAL INTELLIGENCE**

(30) Priority: 29.02.2024 US 202418592005
(71) Applicant: Microsoft Technology Licensing, LLC, Redmond, WA 98052 (US)
(72) Inventor: BRITTO MATTOS LIMA, Andréa, Redmond, 98052 (US); VALLIN SPINA, Thiago, Redmond, 98052 (US); FOWERS, Spencer, Redmond, 98052 (US); O'DOWD, Christopher, Redmond, 98052 (US)
(74) Representative: CMS Cameron McKenna Nabarro Olswang LLP

(57) **Abstract**

Improved manufacturing techniques involve automatically adjusting manufacturing parameters in real time as an object is being manufactured to avoid or reduce manufacturing defects. A 3D printer begins printing an object based on a 3D design and using initial parameters. Cameras perform a volumetric capture of the object as it is being printed. A 3D model of the object being printed is generated in real time. The 3D model and the 3D design are compared to determine the differences and to detect defects. A machine learning model recommends new parameters to compensate for the defects. The 3D printer continues printing the object using the new parameters automatically. Users need not guess the manufacturing parameters or take multiple iterations of trial-and-error to manually adjust the parameters.

## Description

### BACKGROUND

Three-dimensional (3D) printing, or additive manufacturing, is a process of manufacturing an object by building up a print material layer by layer. 3D printing has gained rapid popularity due to its many benefits, including low costs, fast prototyping, and ease of customization. 3D printing has enabled distributed manufacturing, where objects can be manufactured closer to the end user, even at the customers' homes, thus cutting down on warehousing and shipping.

### SUMMARY

The concepts described below relate to automatically adjusting manufacturing parameters in real time using artificial intelligence (Al). In the context of 3D printing, volumetric video capture is used to generate a model of the object being printed. The model is compared to the original design to detect defects in the object. Then, Al recommends parameter adjustments, which are automatically adopted by a 3D printer in real time to eliminate, reduce, or prevent the defects.

Improved manufacturing techniques involve automatically adjusting manufacturing parameters in real time as an object is being manufactured to avoid or reduce manufacturing defects. A 3D printer begins printing an object based on a 3D design and using initial parameters. Cameras perform a volumetric capture of the object as it is being printed. A 3D model of the object being printed is generated in real time. The 3D model and the 3D design are compared to determine the differences and to detect defects. A machine learning model recommends new parameters to compensate for the defects. The 3D printer continues printing the object using the new parameters automatically. Users need not guess the manufacturing parameters or take multiple iterations of trial-and-error to manually adjust the parameters

### BRIEF DESCRIPTION OF THE DRAWINGS

The detailed description below references the accompanying figures. The use of similar reference numbers in different instances in the description and the figures may indicate similar or identical items. The example figures are not necessarily to scale.
FIG. 1 illustrates an example conceptual diagram, consistent with some implementations of the present concepts.
FIG. 2 illustrates an example volumetric capture setup, consistent with some implementations of the present concepts.
FIGS. 3-7 illustrate example manufacturing defects.
FIG. 8 illustrates a flow diagram of an example manufacturing parameter adjusting method, consistent with some implementations of the present concepts.
FIG. 9 illustrates an example manufacturing parameter adjustment system, consistent with some implementations of the present concepts.

### DETAILED DESCRIPTION

Although the concepts described herein can be applied to a wide range of manufacturing applications, the concepts will be described in the context of 3D printing as an example application.

### 3D PRINTING

Generally, a user creates a design of an object that the user wishes to print. The design includes a digital 3D model of the object. For example, the user can use a computer-aided design (CAD) software application to create the design. Furthermore, the user uses a slicer software application to set and adjust various parameters associated with the printing process. The slicer converts the digital design into a series of digital thin layers and generates geometry code (G-code). The G-code includes instructions that a 3D printer and its software can use to print the object. The 3D printer includes print material (e.g., polymers, metals, or ceramics) in the form of filaments. The 3D printer deposits the print material according to the G-code instructions layer by layer to print the object.

### TECHNOLOGICAL PROBLEMS

3D printing is a complex process involving many factors (e.g., parameter settings) that affect the success of manufacturing jobs and the quality of finished products. Accordingly, users often experience frustration and a steep learning curve in making numerous decisions associated with those factors. Users can also face new challenges, be disappointed by low success rates, and be surprised by unexpected results.

For example, the user must choose from a selection of print materials, including polylactic acid (PLA), acrylonitrile butadiene styrene (ABS), thermoplastic elastomer (TPE), high impact polystyrene (HIPS), polyethylene terephthalate (PET), nylon, metal, carbon fiber, and various blends. Different print materials have different properties and thus produce different results, and are prone to different kinds of defects. The user also chooses the resolution of the 3D printer, which determines the level of detail that can be captured in the final product. The user also sets hundreds of parameters in the slicer software, such as layer thickness, nozzle diameter, infill density, print material build chamber temperature, build material extrusion temperature, nozzle temperature, bed temperature, printing speed, build orientation, etc. Each bad parameter setting or a combination of bad parameter settings can create all sorts of defects. For example, the layer height parameter determines the thickness of each layer that is printed. Thicker layers may result in a more visible, blocky, stepped appearance.

Conventionally, the user must guess a set of initial parameters that will be used by the 3D printer based primarily on the user's own experience gained from past 3D printing jobs. However, numerous factors, including bad choices of parameters, can cause defects in the object being printed. Defects can include geometric deviations between the printed object and the original design. Defects can also include artifacts that are common to 3D printing, such as warping or curling, the spaghetti effect, under-extrusion and over-extrusion, stringing, splitting (i.e., layer separation), and surface blobs. Defects can include any other errors or irregularities that render the printed object unexpected or undesirable.

If the printed object includes defects, the user is forced to throw away the defective object, and start a new trial run with different parameter settings. Unfortunately, there is no definitive guidance on how to adjust the parameters to improve the quality of the next iteration. The user typically searches online for guidance from other 3D printing users who have experienced similar defects and found some workable solutions. For example, one blog may suggest increasing the printing speed to eliminate surface blobs, and another commenter may suggest lowering the temperature to avoid the stringing phenomenon. However, spotty suggestions online from random 3D printing enthusiasts often do not resolve the specific problem on hand because there are many different factors that could be causing or contributing to the particular problem. As such, the user is again forced to guess and try different parameters and try the print job again with hopefully better settings that may improve the results. However, it's not uncommon that the parameter adjustments actually worsen the defect or perhaps even cause a whole new set of defects. Accordingly, the user may have to try many iterations of printing, each with a different set of parameters, to obtain acceptable results, unless the user gives up first.

Accordingly, such a crude method of manually adjusting the parameters through multiple iterations of trial-and-error relies heavily on the user's efforts, experience, and intuition. The user must detect any aberrations through careful inspection, correctly identify the nature of the problems, learn the correct terminologies to describe the defects, conduct research through available peers and/or literature for potential solutions (e.g., parameter adjustments), manually implement the parameter adjustments via the slicer, and test multiple iterations of reprinting using new parameter settings. As such, the inexperienced user may misidentify the defect, the guidance online may work for some users but may not work for this user, the user may identify the problem as one thing (e.g., the print material filament) when the actual problem is another thing (e.g., temperature), and so on.

Moreover, even after the user has determined, through extensive trial-and-error, a working set of parameters that produce an acceptable object, the same parameters may not produce the same results in the future because many of the factors that determine the quality of the finished products have changed. For example, ambient temperature and ambient humidity could be different, and therefore generate different results. A set of parameters that works on one 3D printer may not generate the same results on another 3D printer. Even the same print materials from different manufacturers can generate different results. Since there are so many factors that affect the end results, tweaking and finding the optimal set of parameters becomes almost an art form that mixes guesswork, trial-and-error, and a bit of luck.

Furthermore, each iteration can be very time consuming, because a print job can range from several minutes to many hours, even more than 24 hours, depending on the size and complexity of the design as well as the speed of the 3D printer. Each iteration also wastes materials, because defective objects are typically thrown away (or recycled) but cannot be reused by the 3D printer. Thus, multiple iterations are costly in time and money. Moreover, the frustration, anger, despair, and emotional stress experienced by many 3D printing users cannot be overstated.

Existing techniques that try to address some of these problems do not compare the object being printed with the original digital model to detect defects in real time. Also, existing techniques do not automatically suggest parameter adjustments that could eliminate the defects. Accordingly, there is a need for a solution that monitors the progress of manufacturing an object, automatically detects defects in the object being manufactured, and automatically adjusts the manufacturing parameters to reduce or eliminate the defects. The conventional techniques that require user expertise and manual adjustments of manufacturing parameters are unfeasible and impractical, especially for complex designs.

### TECHNOLOGICAL SOLUTIONS

The present concepts, which will be explained in more detail below, involve analyzing the object in real time as the object is being manufactured, detecting defects (such as differences between the original design and the object), and automatically adjusting manufacturing parameters in real time to reduce defects (e.g., increase the similarity between the object and the design).

The object being manufactured can be monitored in many ways. In one implementation, multiple cameras can record the object being manufactured, and volumetric video capture techniques can be used to generate a digital model of the object (e.g., a partial object still being manufactured).

There are also many techniques for detecting defects in the object being manufactured. In one implementation, the digital model of the object being manufactured, which was generated using volumetric capture, can be compared to the original design. The comparison can be performed by mathematical algorithms (e.g., 3D similarity metrics) and/or AI (e.g., machine learning models) to identify deviations in the object from the design. The comparison can reveal manufacturing defects.

Next, the identified defects are used to calculate manufacturing parameter adjustments. In one implementation, Al is employed to predict adjustments to the manufacturing parameters that would reduce or eliminate the defects. These parameter adjustments can be implemented automatically in real time without user intervention, such that the manufacturing machine immediately incorporates the parameter adjustments and continues manufacturing the object using the new parameters.

The object continues to be monitored and if the defects continue or additional defects are found, then additional adjustments are made to the manufacturing parameters. This process continues until the object is completely manufactured.

### OVERVIEW

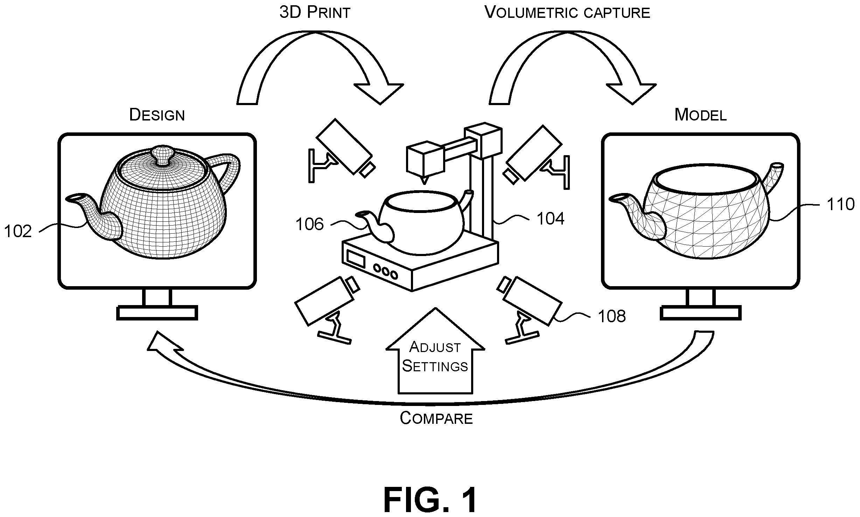

FIG. 1 illustrates an example conceptual diagram, consistent with some implementations of the present concepts. An example implementation of these concepts will be described in the scenario of 3D printing a teapot. A user creates a design 102 of a teapot using, for example, a CAD application. The design 102 includes 3D digital model of a teapot that the user wishes to 3D print. Alternatively, the user can obtain the design 102 that was created by someone else (e.g., download the design 102 from the Internet).

In one implementation, the CAD application outputs the design 102 in STL (standard triangle language or standard tessellation language) format to a slicer application. The user can set initial parameters using the slicer application. For example, the user can accept default parameters in the slicer application or make any adjustments that the user believes are appropriate for the design 102. Alternatively or additionally, Al can suggest optimal initial parameters based on the design 102. The slicer application generates G-code based on the design 102 and the initial parameters, and outputs the G-code to a 3D printer 104 to print an object 106 (a teapot, in this case).

The 3D printer 104 begins manufacturing the object 106 by executing the G-code. As the 3D printer 104 is printing the object 106 layer by layer, cameras 108 capture images of the object 106. The cameras 108 are set up at multiple locations and are recording the object 106 from multiple angles to comprehensively capture the object 106. The images of the object 106 captured by the cameras 108 make up volumetric data and are used to generate a model 110 of the object 106 using volumetric video capture techniques in real time. The model 110 includes a 3D digital model of the object 106 being manufactured (e.g., a bottom portion of the teapot).

Then, the model 110 is compared against the design 102 (or the relevant bottom portion of the design 102 depending on the progress of building the teapot) to detect any defects. The comparison can be performed by mathematical comparison algorithms and/or Al. Furthermore, if defects are detected, then Al can be used to determine appropriate adjustments to the manufacturing settings (e.g., parameters) that would compensate for the defects.

The parameter adjustments recommended by Al can be automatically provided to the 3D printer 104 in real time (e.g., through the slicer application modifying the G-code), and the 3D printer 104 continues making the object 106 using the new parameters. That is, the initial parameters that were used to begin printing the object 106 are replaced with new parameters, as suggested by Al, to reduce or eliminate the detected defects.

The above-described steps repeat continuously as the object 106 is being built by the 3D printer 104. The cameras 108 continually capture the progress of building the object 106 and provide updated volumetric data. An updated model 110 is generated again and again as more and more of the object 106 is built. The newly generated model 110 is compared with the design 102 to find any new defects. New parameter adjustments are predicted by Al to address the defects. The 3D printer 104 adopts the new parameters to continue printing the object 106 to completion. This cycle repeats automatically in real time without user intervention. The various components of these concepts will be described in more detail in reference to subsequent figures.

### VOLUMETRIC CAPTURE

There are many ways to capture and monitor the progress or status of manufacturing the object 106 and then generate the model 110. In some implementations of the present concepts, a rig can be set up to capture the progress of manufacturing the object 106. The rig can include the cameras 108 pointing at the object 106 being printed progressively. And volumetric capture techniques can be employed to generate the model 110 in real time.

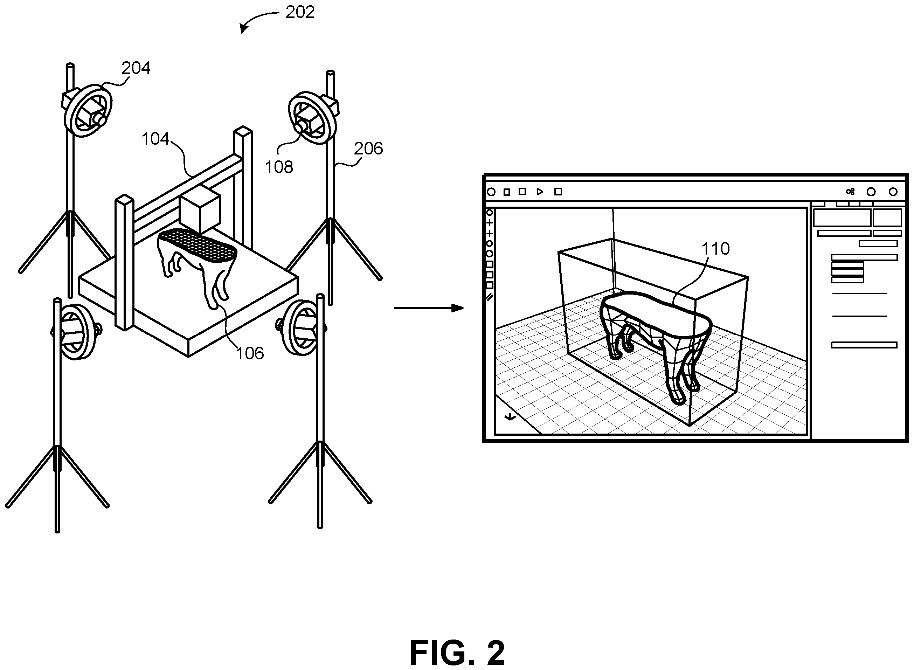

FIG. 2 illustrates an example volumetric capture setup, consistent with some implementations of the present concepts. The volumetric capture setup includes a capture rig 202. In this example, the capture rig 202 can include any number of one or more cameras 108. The cameras 108 can be stationary, or they can move and/or rotate. For example, one or more of the cameras 108 can revolve around the object 106 (an animal in FIG. 2). The cameras 108 can be RGB cameras that can take images or videos of the object 106, or RGBD cameras that can also capture depth information. Other types of cameras or sensors are possible. The capture rig 202 can also include lights 204. The capture rig 202 can include supports 206, such as stands, bars, rails, levers, arms, walls, ceilings, floors, wheels, etc. The cameras 108 and/or the lights 204 can be mounted on the supports 206. The supports 206 can be stationary or movable so that the cameras 108 can capture the object 106 from different locations and angles. For example, in the example illustrated in FIG. 2, the cameras 108 and the lights 204 move up and down the supports 206.

The images of the object 106 captured by the cameras 108 are processed (e.g., isolate the object 106 by removing the background), synchronized (e.g., based on timestamps), and stitched together using volumetric algorithms to construct the model 110 (e.g., a 3D digital reconstruction of the object 106). Thus, the model 110 includes a 3D volumetric model of the (partial) object 106 being 3D printed in real time.

Any volumetric capture techniques (e.g., Microsoft Holoportation^{™}) or any 3D scanning technologies can be employed to generate the model 110 of the object 106. For example, LIDAR (light detecting and ranging) refers to techniques of using scanners that emit laser pulses to measure distances. The distance data can be collected and analyzed to create the model 110. As another example, NeRF (neural radiance field) uses a deep neural network (DNN) to construct a 3D representation from a collection of images from multiple cameras. Moreover, Al (e.g., deep learning) can be used to reconstruct the 3D model from the collected images.

The size and the complexity of the capture rig 202 can vary depending on the manufacturing application scenario. For example, the cameras 108 can be an elaborate collection of different types of cameras and sensors set up on a construction site for a large manufacturing job. In another scenario, the cameras 108 can be installed around a manufacturing machine inside a factory facility. As illustrated in FIG. 2, the cameras 108 can be stand-alone cameras attached to the supports 206 (tripods in this case) set up around the 3D printer 104. On a smaller scale, the cameras 108 can be miniature build-in cameras positioned around the print bed of the 3D printer 104. Furthermore, although these examples described the capture rig 202 as including cameras, the capture rig 202 can include any other type of sensors (such as thermometers for measuring temperature, hygrometers for measuring humidity, or infrared for measuring distance and/or temperature) to capture the environment, conditions, and/or status of the manufacturing process.

### DEFECT DETECTION

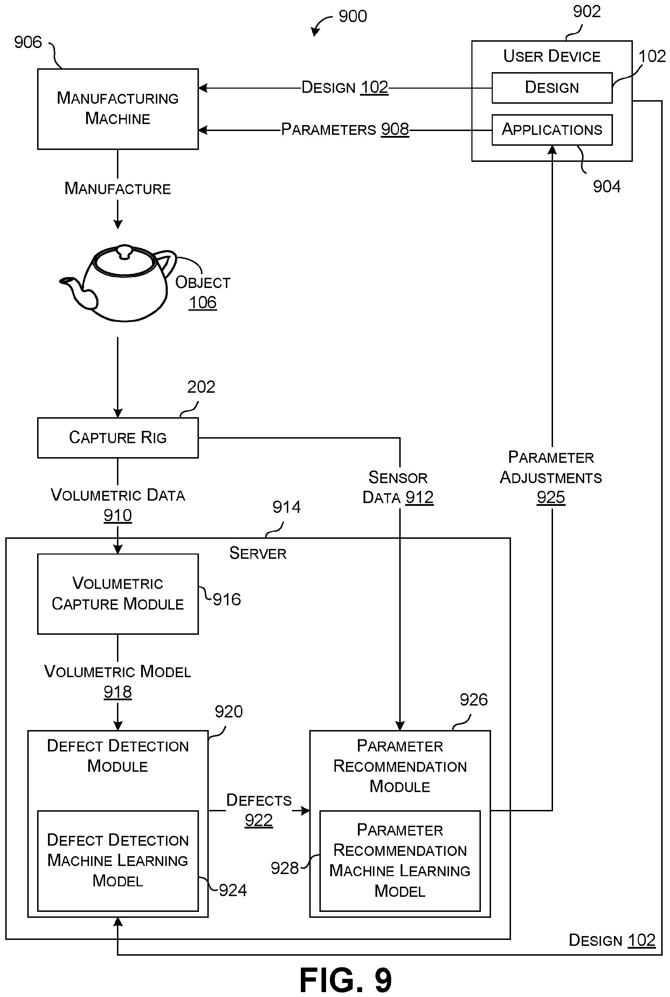

Consistent with the present concepts, a defect detection module (shown in FIG. 9 and explained in more detail below) can employ at least two techniques to detect defects in the object 106. The first technique involves using mathematical algorithms (e.g., geometry) to compare the model 110 of the object 106 against the design 102. The second technique involves using Al to detect defects. The two techniques can be used in combination.

In one implementation, the model 110 that is generated via volumetric video capture while the object 106 is being printed is compared with the corresponding layers (i.e., a bottom portion) of the design 102. There are many techniques that can be used to compare the two 3D models (i.e., the model 110 and the design 102). For example, a mathematical algorithm can check the positions of the vertices, subtract one 3D model from the other, and determine the geometric differences between the two 3D models, via Euclidean Distance, Root Mean Square Deviation (RMSD), or any other desired metric. As another example, 3D similarity metrics can compare the two 3D models and determine a score value that represents the degree of similarity between the two 3D models. The output from the comparison can include a numerical value (e.g., a higher value when the two models are more alike), a 3D geometric model (e.g., a model representing the differences between the two 3D models being compared), or both.

In another implementation, the defect detection module includes a defect detection machine learning model (shown in FIG. 9) that is trained and used to determine the differences between the model 110 and the design 102, and/or detect defects in the model 110. The defect detection machine learning model can include one or more neural networks, such as a perceptron model, feed forward (FF) neural network, multilayer perceptron (MLP), convolutional neural network (CNN), Transformers, radial basis functional (RBF) neural network, recurrent neural network (RNN), long short-term memory (LSTM), sequence to sequence model, and modular neural network.

The defect detection machine learning model is trained using training data. In one implementation, the training data includes a large set of sample 3D models. The training data is annotated with tags or labels that identify various sample defects, such as geometric differences, surface finish anomalies, and any other common manufacturing defects that can occur during 3D printing. For example, common defects include spaghetti artifacts, layer splitting, warping, etc. The training data can include pairs of good 3D models and bad 3D models that are labeled as such. Alternatively or additionally, the training data can include a set of good 3D models and a set of bad 3D models that are not necessarily paired. Alternatively or additionally, the training data can include sample images of 3D printing artifacts that are annotated with appropriate defect categories. The training data can include a collection of real data that are obtained from actual manufacturing jobs and/or a collection of synthetic data that are artificially generated with and without fabricated defects. Accordingly, the defect detection machine learning model can detect defects by comparing the model 110 with the design 102, evaluating the differences between the model 110 and the design 102, evaluating the model 110 alone, and/or evaluating the images of the object 106.

For example, the training data can include thousands of sample models that include spaghetti defects and thousands of sample images of spaghetti defects. Accordingly, the defect detection machine learning model learns to associate specific features in the sample models and in the sample images that are correlated with spaghetti defects, and thereby learns to recognize spaghetti defects during runtime.

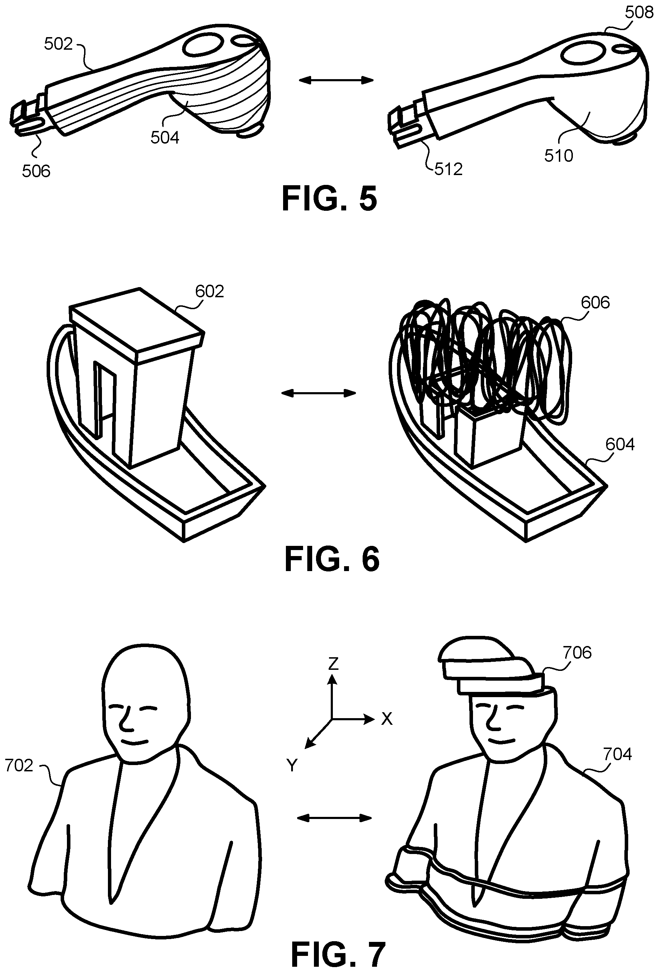

At runtime, depending on the implementation, inputs to the defect detection machine learning model include one or more of: the design 102, the model 110 of the object 106, the images of the object 106 captured by the cameras 108, the digital model of the differences between the model 110 and the design 102, or the similarity score calculated by the 3D similarity metrics. Depending on the implementation, the outputs from the defect detection machine learning model include one or more of: a boolean or a flag indicating that a defect exists or does not exist, the types of defect detected, or the degrees of detected defects. The use of Al can provide more robust results in detecting defects, because certain defects associated with 3D printing are better detected by the defect detection machine learning model than 3D similarity metrics. However, mathematical algorithms can provide faster results than using Al in some cases.
For example, the defect detection machine learning model can detect defects by comparing the model 110 of the object 106 being manufactured with the original design 102, evaluating the model 110 alone and/or evaluating the images of the object 106 being manufactured. The defect detection machine learning model can be trained using thousands of sample 3D models that include spaghetti defects (illustrated in FIG. 6). Then, the defect detection machine learning model learns to associate specific features that are correlated with spaghetti defects, and thereby learns to recognize spaghetti defects in the object 106 being manufactured during runtime. Alternatively or additionally, the defect detection module can use mathematical algorithms (e.g., 3D similarity metrics) and/or Al to compare the original design 102 and the model 110 of the object 106 being manufactured and identify deviations. The comparison can reveal manufacturing defects such as spaghetti.

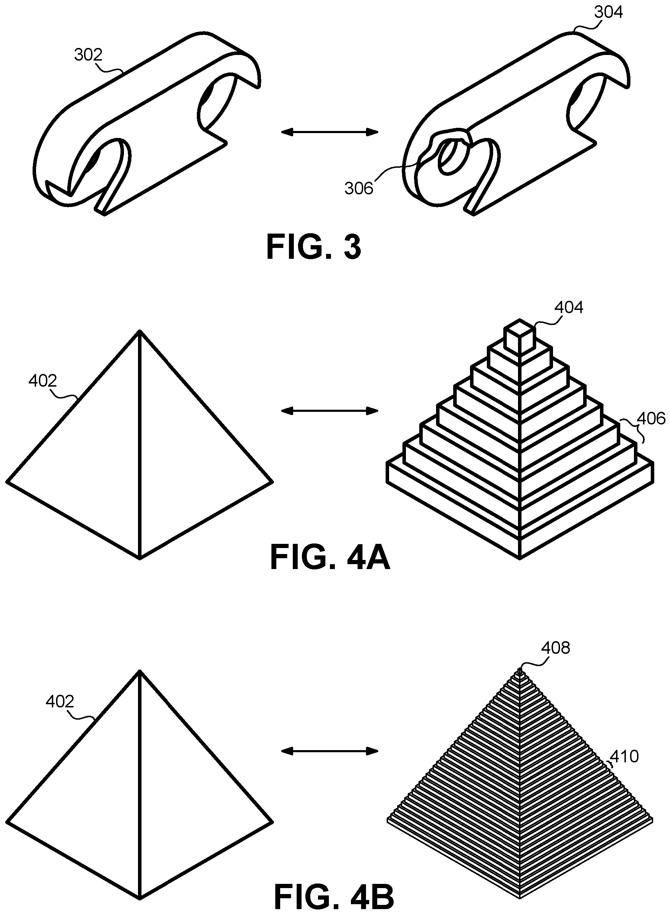

FIGS. 3-7 illustrate example manufacturing defects. Each of FIGS. 3-7 includes an example design on the left-hand side and an example object (or a model of the object) that has a defect on the right-hand side.

In FIG. 3, a design 302 is a shoe cabinet part. An object 304, which has been 3D printed from the design 302, has a fracture 306. The fracture 306 resulted from a piece of the object 304 breaking off, perhaps due to a bad set of parameters (e.g., bad print material, bad extrusion temperature, bad extrusion speed, etc.). The fracture 306 is a type of defect that can be detected by mathematical algorithms that compare the geometry of the design 302 and the geometry of a volumetric model of the object 304.

Furthermore, the defect detection machine learning model can also detect and/or confirm the defect (the fracture 306 in this example) by either comparing the shapes of the design 302 and the volumetric model of the object 304, or by analyzing the volumetric model of the object and/or images of the object 304. For example, the fracture 306 may leave a rough, grainy, uneven surface compared to the smooth, shiny surface on the rest of the object 304. This difference can be detected by the defect detection machine learning model.

In FIGS. 4A and 4B, a design 402 is a pyramid. An object 404 in FIG. 4A includes a large stepping defect 406. The large stepping defect 406 resulted from forming the object 404 layer by layer, where the layer height (also called the layer thickness) parameter is too high. The large stepping defect 406 can be detected using, for example, 3D similarity metrics to compare the design 402 with a model of the object 404.

In one implementation, the severity of the difference between the design 402 and the object 404 can be compared to a threshold to determine whether there is a defect. For example, the severity of the difference between the design 402 and the object 404 can be measured by volume size, the longest length, or any other geometric measurements. For instance, the similarity score measured by 3D similarity metrics can be compared with a threshold value. The threshold can be an absolute value or a relative value (e.g., a percentage of the total volume or other deviation metrics).

In another example, FIG. 4B shows the same design 402 of a pyramid. An object 408 in FIG. 4B includes a small stepping defect 410. The severity of the small stepping defect 410 in FIG. 4B is less than the severity of the large stepping defect 406 in FIG. 4A due to a smaller layer height parameter. Depending on the threshold for determining a defect, the large stepping defect 406 may be considered a defect, while the small stepping defect 410 may not be considered a defect.

This scenario is one example where using the defect detection machine learning model can be more beneficial than using just mathematical algorithms to geometrically compare the design 402 and the object 408. Manually setting a threshold as a cutoff for what is considered a defect versus what is considered an acceptable deviation is cumbersome and overly complex, because different types of defects for different shapes and different applications can vary. Also, having a human designer pick the acceptable tolerance for a deviation may be biased. Instead, the defect detection machine learning model can learn through numerous examples (e.g., thousands or millions) in the training data that are labeled as bad defects or tolerable variations for all kinds of defects and shapes. Moreover, the defect detection machine learning model can be specialized to a particular user (e.g., a particular corporation) to learn the degrees and types of defects that are tolerable versus unacceptable.

In FIG. 5, a design 502 is a medical device. The design 502 includes slanted surfaces 504 (similar to a slightly uneven beveled siding) to create more friction with a user's fingers and prevent slippage. The design 502 also includes a tapered clip 506 that has a tapered shape to facilitate fitting it into a connection component. However, an object 508, which was 3D printed from the design 502, has a smooth surface 510 instead of the slanted surfaces 504 and has a non-tapered clip 512 instead of the tapered clip 506. These defects may have resulted from bad parameters, such as low resolution. Some parameters that affect the resolution (e.g., the size of the smallest detail that can be printed) can include, for example, print speed, layer height, line width, and print material. Accordingly, bad parameters can cause the object 508 to be missing some of the finer details in the design 502. The example defects in the object 508 (i.e., the smooth surface 510 and the non-tapered clip 512) would not have been identified as defects by conventional techniques that do not compare the object 508 with the original design 502. That is, there is nothing inherently wrong with the smooth surface 510 and the non-tapered clip 512 other than the fact that they were not the intended result. But, consistent with the present concepts, such defects can be identified by comparing the object 508 (or a model of the object 508) against the design 502 via a mathematical comparison and/or using the defect detection machine learning model. The defects can also be identified by analyzing images of the object 508, because the smooth surface 510 and the non-tapered clip 512 in the images can be recognized as being inconsistent with the design 502.

In FIG. 6, a design 602 is a boat (e.g., a toy boat or a model boat). FIG. 6 also shows an object 604 that was 3D printed from the design 602. The object 604 includes a spaghetti artifact 606. The spaghetti artifact 606 is a tangled mess of excess print material that oozed out uncontrollably from the printer nozzle. The spaghetti artifact 606 is a very common type of defect in 3D printing. This defect could have been caused by a bad temperature parameter (high temperature liquifies the filament and causes it to ooze out), a bad speed parameter (high speed can result in uncontrolled extrusion of print material), or a bad retraction distance parameter (low retraction distance can cause print material to drip out of the printer nozzle). The spaghetti artifact 606 can be detected by a geometric comparison and/or by the defect detection machine learning model. Because the defect detection machine learning model has been trained using many examples of known, common defects associated with 3D printing, the defect detection machine learning model can robustly, reliably, and quickly recognize the spaghetti artifact 606 as well as other types of defects. For example, many defects that are common to 3D printing (such as the spaghetti artifact 606, layer splitting, and surface blobs) have specific characteristics that the defect detection machine learning model can learn to identify early in their formation. Accordingly, even if a defect is minor at the beginning of its formation, such that a geometric comparison would consider the deviation insignificant for falling below a threshold, the defect detection machine learning model can still flag the deviation as a defect based on its characteristics that match a known and learned defect category.

In FIG. 7, a design 702 is a bust. An object 704, which has been 3D printed from the design 702, has a slipping defect 706 (also called a sliding effect). The slipping defect 706 refers to certain layers that are off position along the x-axis and/or the y-axis, and appear to have slipped or slid sideways from where the layers are supposed to be. The slipping defect 706 could have resulted from bad parameters, such as a high acceleration setting (causing the extruder to jerk) or a low temperature setting (causing the extruder to slip because it cannot push the print material ahead).

One advantage of comparing the object 106 being manufactured with the design 102 is that the present concepts can quickly discern any deviations from the design 102 and thus better identify defects. Conventional manufacturing techniques do not compare the object 106 with the original design 102, and thus would be unable to discern whether something that seems like a defect (e.g., the spaghetti artifact 606 or the slipping defect 706) is part of the original design 102 or not. Furthermore, another advantage is that the present concepts enable early detection and prevention of defects, long before the defects become noticeable or substantial. For example, the spaghetti artifact 606 can be detected early, long before the defect grows into the large mess illustrated in FIG. 6.

### PARAMETER OPTIMIZATION

The present concepts involve automatically optimizing manufacturing parameters using a parameter recommendation module (shown in FIG. 9 and explained in more detail below). The parameter recommendation module can employ rule-based algorithms and/or Al to determine new parameters that would yield improved manufacturing results based on the defects detected by the defect detection module described above. In one implementation, the parameter recommendation module includes a parameter recommendation machine learning model (shown in FIG. 9) that is trained and used to predict better manufacturing parameters. The parameter recommendation machine learning model can include one or more neural networks, such as a perceptron model, FF neural network, MLP, CNN, Transformer, RBF neural network, RNN, LSTM, sequence to sequence model, and modular neural network.

The parameter recommendation machine learning model is trained using training data. In one implementation, the training data includes a large set of sample designs and corresponding optimal manufacturing parameters. In the context of 3D printing, the training data can include thousands, millions, or billions of sample 3D designs and corresponding optimal 3D printing parameters. Such training data enables the parameter recommendation machine learning model to associate ideal or acceptable parameters with certain 3D designs. Additionally or alternatively, the training data includes sample parameters that are labeled good and/or parameters that are labeled bad. Such training data enables the parameter recommendation machine learning model to learn both acceptable parameters and problematic parameters. Additionally or alternatively, the training data includes sample 3D models of objects that were printed based on the sample 3D designs using the corresponding parameters, where the parameters and/or the 3D models are tagged as good or bad, annotated with defect categories, and/or annotated with the degree/severity of the defects. The parameters in the training data can include adjustable parameters (e.g., layer height, print speed, nozzle temperature, etc.) as well as fixed parameters or conditions (e.g., room temperature, ambient humidity, print material type, 3D printer models and specifications, etc.) that can affect the quality of the print. Such training data enables the parameter recommendation machine learning model to learn successful associations between good parameters and desirable print quality, as well as learn potential causal relationships between bad parameters and various kinds of defects.

The training data can include real historical data that are obtained from real life manufacturing experiences and/or synthetic data that are artificially generated. The real historical data can be collected from real users and their attempts at 3D printing. For example, with the users' permission, their 3D print jobs can be logged (including the design and the parameters used). The users' satisfaction or dissatisfaction with the print quality can be manually obtained based on the users' feedback or automatically inferred based on whether the users repeat the same print job with parameter adjustments, repeat the same print job using the same parameters, and/or end printing altogether. The real historical data can also be built in a controlled environment through many trials of actual 3D printing jobs using various parameter adjustments. These trials can involve, for example, 3D printing the same design ten times using sequentially increasing layer height parameter values while keeping other parameters constant. Accordingly, the parameter recommendation machine learning model can be trained to map good parameters with certain designs and also learn to adjust the parameters to compensate for certain defects.

For example, the training data can include thousands of sample designs and corresponding parameters that resulted in layer splitting defects as well as thousands of sample designs and corresponding parameters that did not result in layer splitting defects. Accordingly, the parameter recommendation machine learning model learns which parameter values (or which combinations of parameter values) cause or avoid layer splitting defects. Thus, the parameter recommendation machine learning model learns to recommend initial parameters or parameter adjustments that avoid layer splitting defects during runtime.

After training and during runtime use, inputs to the parameter recommendation machine learning model include one or more of: parameters currently being used to 3D print the object 106 (including specifications associated with the 3D printer 104 and environmental conditions), any defects detected by the defect detection module, the design 102, and/or the model 110 of the object 106.

Outputs from the parameter recommendation machine learning model include a set of parameter recommendations. The parameter recommendations can include an entirely new set of parameters, a subset of new parameters, a set of parameter adjustments relative to the current set of parameters, or a null set (or some other indicator to not adjust the current set of parameters). For example, if the defect detection module has not identified any defects (e.g., the model 110 is similar to the design 102), then the parameter recommendation machine learning model outputs an indication to keep the current parameters. However, if the defect detection module identifies defects (e.g., there are discrepancies between the model 110 and the design 102, and/or the object 106 includes artifacts), then the parameter recommendation machine learning model outputs one or more new parameters. For example, the new parameters output by the parameter recommendation machine learning model can include a new temperature setting, a new type of print material, a new layer height value, a speed adjustment amount (e.g., as an incremental speed value or as an incremental speed percentage), a new pressure setting, a new feed rate, etc. The parameter recommendation machine learning model can be trained to consider many parameters (e.g., parameters for the 3D printer 104 and parameters for the print material) and provide an output that can potentially change any of the multiple parameters. Accordingly, the parameter recommendation machine learning model is capable of identifying inappropriate parameters that should be fixed in order to produce high quality print jobs.

In one implementation, the parameters that are input to the parameter recommendation machine learning model can include metadata, such as indications (e.g., flags) about whether the parameters are adjustable or fixed, and ranges of parameter values (e.g., the minimum value and the maximum value). For example, some of the parameters may be fixed conditions that are not adjustable (e.g., environmental conditions such as ambient temperature, ambient humidity, and ambient pressure as well as 3D printer specifications such as resolution, maximum speed, etc.). Furthermore, adjustable parameters (such as temperature and speed) have minimum and maximum bounds). Accordingly, the parameter recommendation machine learning model considers fixed parameters as well as the ranges of the adjustable parameters when outputting a recommendation of parameter adjustments within their allowable ranges.

In some implementations, the parameter recommendation module provides the output in real time. Accordingly, the new parameters can be automatically used by the 3D printer 104 (i.e., the object 106 continues to be 3D printed using adjusted parameters) and avoid reprinting iterations.

The above examples describe the defect detection machine learning model and the parameter recommendation machine learning model as separate models. However, in some implementations, the two machine learning models can be combined into one machine learning model. For example, the combined machine learning model can include a deep neural network having multiple hidden layers (also called intermediate layers) between the input layer and the output layer, where the earlier layers detect defects and the later layers recommend parameters. Furthermore, there could be significant overlap between the training data for the defect detection machine learning model and the training data for the parameter recommendation machine learning model. Hence, combining the two machine learning models can streamline the training endeavor.

Similarly, the defect detection module and the parameter recommendation module, which have been described above as two separate modules, can be combined into one module. For example, in one implementation, the combined module can use 3D similarity metrics to detect defects and then use the parameter recommendation machine learning model to determine parameter adjustments to reduce or eliminate the defects. Other combinations are possible.

In addition to providing parameter recommendations to compensate for defects detected during a manufacturing job, in one implementation, the parameter recommendation machine learning model provides a set of initial parameters to begin the manufacturing job. For this implementation, the inputs to the parameter recommendation machine learning model include the design 102 and any relevant conditions (e.g., ambient temperature, humidity, pressure, etc.) and fixed settings (e.g., the specifications of the 3D printer 104) but does not include any defects because 3D printing has not yet begun. The parameter recommendation machine learning model outputs a suggestion of initial parameters to start the 3D print job. And, as discussed above, if defects are detected while printing the object 106 using these initial parameters, then the parameter recommendation machine learning model suggests adjustments to those initial parameters.

In some implementations, the defect detection machine learning model and/or the parameter recommendation machine learning model are continued to be trained (or improved) by receiving feedback from users on the quality of the print jobs (e.g., the accuracy of defect detection and/or the success of parameter recommendations). For example, users can manually provide feedback (e.g., a numerical rating from 1 through 5, thumbs-up button, thumbs-down button, etc.). Additionally or alternatively, the quality of the print job can be inferred based on a number of factors. For example, bad parameters can be inferred when another iteration of the same print job (e.g., the same design 102) is initiated but using a different set of parameters. Conversely, good parameters can be inferred when multiple iterations of the same print job with the exact same parameters are initiated or no more print job is initiated, because the last print job was satisfactory. Therefore, the machine learning models continue to learn from each manufacturing iteration. And over time, the machine learning models become smarter at detecting defects, recommending parameter adjustments, recommending initial parameters, and avoiding defects altogether.

### PROCESSES

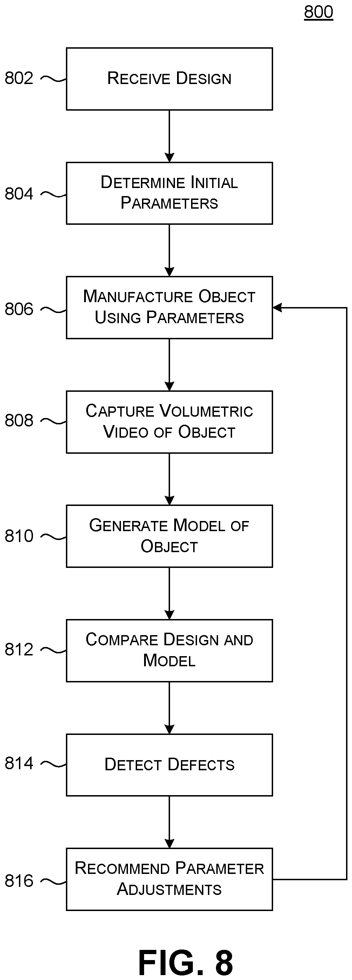

FIG. 8 illustrates a flow diagram of an example manufacturing parameter adjusting method 800, consistent with some implementations of the present concepts. The manufacturing parameter adjusting method 800 is presented for illustration purposes and is not meant to be exhaustive or limiting. The acts in the manufacturing parameter adjusting method 800 can be performed in the order presented, in a different order, or in parallel or simultaneously; can be omitted; can be repeated; or can include intermediary acts therebetween. The manufacturing parameter adjusting method 800 is explained below in the context of 3D printing but can be applied to other manufacturing fields.

In act 802, a design is received. The design includes a 3D model of an object (e.g., a product or an article) that will be 3D printed. The object can be called a print. In one implementation, the design is received from a user who created the design, for example, using a CAD software application. In another implementation, the design is downloaded from a third-party source, such as a database of 3D digital design models on the Internet.

In some implementations, the design is analyzed by a slicer to prepare for 3D printing. That is, the slicer breaks up the 3D model in the design into a plurality of layers (i.e., slices) that can be printed by a 3D printer one layer at a time.

In act 804, initial parameters are determined. In one implementation, the initial parameters that will be used to 3D print the object using the design are provided by the default parameters in the slicer. In another implementation, the initial parameters are provided by a user who inputs the initial parameters, for example, via the slicer. The initial parameters provided by the user represents the user's guess on parameter values that hopefully will result in acceptable print results based on the user's experience and knowledge. In yet another implementation, the initial parameters are provided by Al, such as a parameter recommendation machine learning model. The design is input to the parameter recommendation machine learning model, which outputs a suggestion of initial parameters. The initial parameters determined by the parameter recommendation machine learning model are a product of learning from large training data of numerous examples of designs and corresponding optimal parameters. Moreover, any combination of these three implementations are possible. For example, the user can modify a subset of the default parameters in the slicer or modify a subset of the parameter suggestions from the parameter recommendation machine learning model.

In act 806, the object is manufactured based on the design using the initial parameters. For example, the slicer generates G-code based on the design and the initial parameters. The 3D printer executes the G-code and begins building the object by extruding print material starting from the bottom layer and continuing upward layer after layer. Although act 806 is depicted once in FIG. 8, act 806 is an ongoing act that continues until the object is completely built. That is, act 806 does not necessarily end when subsequent acts (e.g., act 808 through act 816) begin.

In act 808, a volumetric video of the object is captured. In one implementation, multiple cameras capture synchronized videos (i.e., a sequence of timestamped images) of the object from multiple angles while the object is being built by the 3D printer. Similar to act 806, act 808 is also an ongoing act. That is, the cameras continuously capture volumetric videos of the object as the 3D printer continues to build the object layer by layer. Thus, act 808 does not necessarily end when subsequent acts (e.g., act 810 through act 816) begin. Moreover, although act 808 is depicted after act 806 in FIG. 8, act 808 can be initiated before act 806 or at the same time as when act 806 is initiated. For example, the cameras can begin to capture volumetric videos before or at the start of the 3D printer building the object.

In act 810, a model of the object being manufactured is generated. For example, a 3D volumetric model is generated from the volumetric video data captured by the cameras in act 812. The 3D volumetric model is a real-time digital representation of the physical object being built by the 3D printer. If the object has not been completely manufactured yet, then the volumetric model would represent a part (e.g., the bottom portion) of the would-be-complete object.

In act 812, the design received in act 802 and the model generated in act 810 are compared. Since the model represents an incomplete object, the model is compared to the corresponding bottom portion of the design. For example, 3D similarity metrics can be used to perform the comparison. Other mathematical techniques for comparing two 3D geometric shapes can be used to perform the comparison.

In act 814, defects are detected. For example, the comparison performed in act 812 identifies any differences between the design and the model, thereby revealing unwanted deviations in the object from the design. If the differences are substantial (e.g., above a certain threshold), the differences are deemed defects. Additionally or alternatively, a defect detection machine learning model detects defects, for example, based on the comparison performed in act 812, the design received in act 802, the model of the object generated in act 810, and/or the images captured by the cameras in act 808.

If a defect is detected, then one or more of the parameters being used is faulty and should be adjusted. In one implementation, a stop signal is sent to the 3D printer as soon as a defect is flagged so that the 3D printer can pause printing the object using bad parameters before the defect worsens. Upon receiving the stop signal, the 3D printer can immediately pause printing or pause at a feasible stopping point (e.g., as soon as the extrusion can be stopped or after the current layer finishes).

In act 816, parameter adjustments are recommended. For example, a parameter recommendation machine learning model estimates a recommendation of parameter adjustments based on the defects, the current parameters, the design, and/or the model of the object. The objective of the parameter adjustments is to eliminate or reduce the detected defects.

Next, the parameter adjustments are automatically sent to the 3D printer. For example, the parameter adjustments are sent to the slicer, which generates new G-code using the new parameters and sends the new G-code to the 3D printer. If the 3D printer had paused printing the object, then the 3D printer automatically resumes printing the object using the new parameters. If the 3D printer has not paused printing the object, then the 3D printer automatically incorporates the new parameters as soon as practicable.

The loop shown in FIG. 8, which includes acts 806 through 816, continues to cycle multiple times throughout the period of 3D printing the object. The cameras continuously capture the object being printed, an updated model of the object is generated, and a new comparison is performed to detect any new defects in each cycle. If no defects are detected, then the 3D printer can continue to print the object using the current set of parameters. If a defect exists in the object, then the manufacturing parameter adjusting method 800 detects the defect in real time and quickly adjusts the parameters to reduce or eliminate any future defects and prevent the worsening of the existing defect. This cycle continues until the 3D printer finishes printing the object. There may be zero, one, or multiple defects detected and zero, one, or multiple parameters adjusted during one print job. If defects are detected early and parameters are adjusted quickly, then the severity of any defects in the finished object should be negligible or at least acceptable so that the object won't be scrapped by the user. Accordingly, the manufacturing parameter adjusting method 800 avoids the need for reprinting iterations.

### SYSTEMS

FIG. 9 illustrates an example manufacturing parameter adjustment system 900, consistent with some implementations of the present concepts. FIG. 9 includes a high-level architectural diagram of some components of the manufacturing parameter adjustment system 900. These example components can be implemented in hardware and/or software, on a common device or on different devices. The number of the components, the types of components, and the conceptual division or separation of the components in FIG. 9 are not meant to be limiting.

In one implementation, the manufacturing parameter adjustment system 900 includes a user device 902. The user device 902 can include a server computer or a client computer, such as a desktop computer, a laptop, a tablet, or a smartphone. Alternatively, the user device 902 can be integrated into a manufacturing machine 906, such as a user console on a manufacturing equipment. The user device 902 includes processing resources for performing certain functionalities by executing instructions, and also includes storage resources for storing applications 904 and data. The user device 902 can be used by a user, for example, to initiate a manufacturing job.

In one implementation, the user device 902 includes the applications 904. The applications 904 include manufacturing software applications, such as a CAD program and a slicer application for 3D printing. The user can use the applications 904 to create the design 102 of the object 106 that the user wishes to manufacture using the manufacturing machine 906. In this example scenario, the object 106 is a teapot and the manufacturing machine 906 is the 3D printer 104. However, the object 106 can be any other article or a product, and the manufacturing machine 906 can be any kind of manufacturing equipment. Furthermore, the user can use the applications 904 to set parameters 908 for manufacturing the object 106.

In one implementation, the design 102 and the parameters 908 are sent to the manufacturing machine 906 so that the manufacturing machine 906 can manufacture the object 106 using the design 102 and the parameters 908. In the context of 3D printing, the slicer application incorporates the design 102 and the parameters 908 into G-code that is sent to the 3D printer 104. Then, the 3D printer 104 executes the G-code, thereby printing the object 106 layer by layer.

In one implementation, the manufacturing parameter adjustment system 900 includes the capture rig 202 for capturing the status of manufacturing the object 106. The capture rig 202 can include sensors for capturing the object 106 as it is being manufactured as well as capturing any environmental conditions. For example, the capture rig 202 can include RGBD cameras, thermometers, hydrometers, barometric pressure sensors, etc. The RGBD cameras capture volumetric data 910 (e.g., images of the object 106 from multiple angles). The thermometers, hydrometers, and barometric pressure sensors capture sensor data 912.

In one implementation, the manufacturing parameter adjustment system 900 includes a server 914. In this example, the server 914 includes a volumetric capture module 916. The volumetric capture module 916 receives the volumetric data 910 (e.g., streams of timestamped images of the object 106 from synchronized cameras) from the capture rig 202, fuses the images, and generates a volumetric model 918 of the object 106 being manufactured.

In one implementation, the server 914 includes a defect detection module 920. The defect detection module 920 receives the volumetric model 918 from the volumetric capture module 916, receives the design 102 from the user device 902, and detects defects 922. The defect detection module 920 include a defect detection machine learning model 924 for analyzing the volumetric model 918 to identify the defects 922.

In one implementation, the manufacturing parameter adjustment system 900 includes a parameter recommendation module 926. The parameter recommendation module 926 receives the defects 922 from the defect detection module 920, and optionally receives the sensor data 912 from the capture rig 202, and calculates a set of parameter adjustments 925 to fix the defects 922. The parameter recommendation module 926 includes a parameter recommendation machine learning model 928 for estimating the parameter adjustments 925. The parameter recommendation module 926 transmits the parameter adjustments 925 to the user device 902, which then controls the manufacturing machine 906 to continue manufacturing the object 106 using the parameter adjustments 925.

The server 914 can include one or more server devices, each having processing resources and storage resources. Accordingly, the volumetric capture module 916, the defect detection module 920, and the parameter recommendation module 926 can be in the same server device or distributed among multiple server devices. These server devices can serve different functions or can be load-balanced to serve the same or shared functions. In one implementation, the volumetric capture module 916, the defect detection module 920, and the parameter recommendation module 926 run one or more remote services (e.g., cloud-based services) that can be accessed via application programming interfaces (APIs) and/or other communication protocols (e.g., hypertext transfer protocol (HTTP) calls). Although FIG. 9 depicts the volumetric capture module 916, the defect detection module 920, and the parameter recommendation module 926 as being implemented on the server 914, their functionalities may be implemented on client computers, such as the user device 902, or implemented on the manufacturing machine 906. For example, the entirety of the manufacturing parameter adjustment system 900 may be implemented and self-contained in one device (e.g., the 3D printer 104). Alternatively, a desktop computer can implement the user device 902 and the server 914, and the desktop computer can be connected to and control the manufacturing machine 906 (such as the 3D printer 104). The choice between implementing these various components locally versus remotely can depend on local computing capabilities and remote data transmission bandwidth and speed.

The transmission of information (e.g., the design 102, the parameters 908, the volumetric data 910, the sensor data 912, the volumetric model 918, the defects 922, and the parameter adjustments 925) may be performed through one or more networks. The networks can be wired and/or wireless. The networks can include, for example, Wi-Fi, Bluetooth, NFC, infrared, Ethernet, cellular, etc., and may include the Internet.

In one implementation, the server 914 (or one or more of the server devices included in the server 914) is configured according to an operating system (OS) centric configuration. The OS centric configuration is organized into one or more applications, an OS, and hardware. In another implementation, the server 914 (or one or more of the server devices included in the server 914) is configured according to a system on chip (SoC) configuration. The SoC configuration is organized into shared resources, dedicated resources, and an interface therebetween. Both device configurations (i.e., the OC centric configuration and the SoC configuration) include at least a storage and at least a processor. The SoC configuration can be thought of as an SoC-type design. In such a case, the functionality provided by the device can be integrated on a single SoC or multiple coupled SoCs. One or more processors can be configured to coordinate with the shared resources, such as the storage, and/or the dedicated resources, such as hardware blocks configured to perform certain specific functionalities.

The term "device," "computer," or "computing device" can mean any type of device that has some amount of processing capability and/or storage capability. Processing capability can be provided by one or more hardware processors that can execute data in the form of computer-readable instructions to provide a functionality. The term "processor" as used herein can refer to one or more central processing units (CPUs), graphical processing units (GPUs), controllers, microcontrollers, processor cores, or other types of processing devices, which may reside in one device or spread among multiple devices. Data, such as computer-readable instructions and/or user-related data, can be stored on storage, such as storage that can be internal or external to the device. The term "storage" can include any one or more of volatile or nonvolatile memory, hard drives, flash storage devices, optical storage devices (e.g., CDs, DVDs etc.), and/or remote storage (e.g., cloud-based storage), among others. The term "computer-readable medium" can include transitory propagating signals. In contrast, the term "computer-readable storage medium" excludes transitory propagating signals.

Generally, any of the functions described herein can be implemented using software, firmware, hardware (e.g., fixed-logic circuitry), or a combination of these implementations. The term "component" or "module" as used herein generally represents software, firmware, hardware, whole devices or networks, or a combination thereof. In the case of a software implementation, for instance, these may represent program code that performs specified tasks when executed on one or more processors. The program code can be stored in one or more computer-readable memory devices, such as computer-readable storage media. The features and techniques of the component are platform-independent, meaning that they can be implemented on a variety of commercial computing platforms having a variety of processing configurations.

### APPLICATIONS

Although the concepts described herein were explained above in the example context of 3D printing, these concepts can be used in other fields of manufacturing. These concepts can optimize various manufacturing techniques from 3D printing and computer numerical control (CNC) to metal additive manufacturing, composites, metal stamping, injection molding, subtractive manufacturing, etc., by implementing cycles of real-time measurements and automatic parameter adjustments.

For example, a CNC mill using subtractive manufacturing techniques begins with a block of metal. A manufacturing machine removes specific portions of the metal block according to a design via turning, milling, drilling, grinding, cutting, and/or boring. Applying the present concepts, the metal block can be scanned in real time as portions of it are being cut away. The scan data is compared with the design. If any defects are detected, then appropriate manufacturing parameters (e.g., dimensional tolerance, speed, temperature, etc.) can be adjusted to continue the removal process. For example, the G-code for the subtractive manufacturing machine can be updated in the middle of shaping the metal block.

### TECHNOLOGICAL ADVANTAGES

The concepts described herein have technical effects that provide many advantages. For example, conventional manufacturing process involves inspecting the manufactured object after it is completely manufactured to detect any defects. The present concepts, however, examine the object while it is being manufactured to catch defects early and quickly adjust manufacturing parameters to prevent further defects. This quick action minimizes any defects and salvages the current object, avoiding the need for reprints.

Accordingly, manufacturing times are significantly reduced by avoiding multiple manufacturing iterations using different trial parameters. Additionally, manufacturing costs are reduced by eliminating (or at least decreasing the amount of) wasted print material that is scrapped due to low quality results. Manufacturing costs are further cut down by consuming less electricity and reducing wear-and-tear on the manufacturing machines. Generating less waste and conserving electricity are also beneficial to the environment.

Additionally, training machine learning models to automatically optimize manufacturing parameters takes human guesswork out of the manufacturing process. That is, users no longer need to try to guess the best set of parameters and then manually adjust the parameters again and again, iteration after iteration. Therefore, the quality of manufacture is no longer dependent on user experience, user training, and user effort. Accordingly, obtaining quality objects is attainable even for beginner users just as much as for advanced users. Thus, users are no longer burdened with educating themselves on hundreds or thousands of manufacturing parameters and how they affect the quality of the resulting object. Moreover, conventional 3D printing is tricky, cumbersome, troublesome, stressful, and even frustrating with low success rates, and requires many rounds of trial and error. Using the present concepts, 3D printing can now be easy, enjoyable experience with high success rates that requires minimal effort. Thus, many more users can enjoy the benefits and joys of distributed manufacturing, such as 3D printing.

Furthermore, automating the steps of detecting defects and adjusting manufacturing parameters eliminates the need for user intervention. For example, a user can start a print job, leave the 3D printer while the object is being printed (which could take hours) with confidence that the 3D printer will automatically take care of any parameter adjustments that may be needed, and then return to the 3D printer after the object has been completely printed. Whether the initial parameters worked without any adjustments or whether there were multiple parameter adjustments along the way, the user need not concern herself.

Using Al is conducive to solving the problem of finding workable parameters when there are so many parameters whose precise interrelationships are not well known. While a human user may require decades of experience to gain knowledge of which parameters affect which defects, machine learning models can be trained much faster with a whole lot more examples of training data.

Also, as mentioned above, the present concepts compare the object with the original design. Therefore, the defect detecting module is aware of the original design and thereby detect defects more effectively.

### ADDITIONAL EXAMPLES

Alternatively or in addition to the other examples described herein, examples include any combination of the following:
Clause A. A system, comprising: a storage including instructions; and a processor for executing the instructions, the instructions including: a defect detection module for: receiving a model of an object being manufactured based on a design and using parameters; comparing the design and the model; and detecting in real time a defect in the object being manufactured; and a parameter recommendation module for recommending an adjustment to the parameters to reduce the defect.
Clause B. The system of clause A, wherein the instructions further include: a volumetric capture module for: receiving images of the object being manufactured; and generating the model based on the images.
Clause C. The system of clause B, further comprising: cameras for capturing the images of the object being manufactured.
Clause D. The system of clause C, wherein the cameras are positioned to capture the images of the object from multiple different angles.
Clause E. The system of any preceding clause, wherein the parameter recommendation module includes a parameter recommendation machine learning model.
Clause F. The system of any preceding clause, wherein the defect detection module includes a defect detection machine learning model for detecting defects based on the model.
Clause G. The system of any preceding clause, wherein the defect detection module uses similarity metrics to compare the design and the model.
Clause H. The system of any preceding clause, further comprising: a manufacturing machine for: manufacturing the object based on the design and using the parameters; receiving the adjustment to the parameters while the object is being manufactured; and continuing to manufacture the object using the adjustment to the parameters.
Clause I. The system of any preceding clause, wherein the manufacturing machine is a 3D printer.
Clause J. A computer-implemented method, comprising: comparing a design and a model of an object being manufactured by a manufacturing machine using a current parameter; detecting a defect in the object based on comparing the design and the model; determining a new parameter based on the defect, the new parameter being an adjustment to or a replacement of the current parameter; and transmitting the new parameter to the manufacturing machine to continue manufacturing the object using the new parameter.
Clause K. The computer-implemented method of clause J, further comprising: capturing a volumetric video of the object while the object is being manufactured; and generating the model based on the volumetric video.
Clause L. The computer-implemented method of clause J or clause K, further comprising: using a parameter recommendation machine learning model to determine the new parameter.
Clause M. The computer-implemented method of clause L, further comprising: training the parameter recommendation machine learning model using training data including sample designs, sample models, sample defects, and sample parameters.
Clause N. The computer-implemented method of clause L, further comprising: determining an initial parameter using the parameter recommendation machine learning model based on the design before manufacturing of the object begins.
Clause O. The computer-implemented method of any of clauses J to N, wherein the design and the model are compared using similarity metrics.
Clause P. The computer-implemented method of any of clauses J to O, wherein: the manufacturing machine is a 3D printer; and the new parameter is transmitted to a slicer.
Clause Q. A computer-readable storage medium storing instructions that are executable by a processor, the instructions comprising: a volumetric capture module for generating a model of an object being manufactured based on a design and using current parameters; a defect detection module for comparing the model and the design to detect defects in the object being manufactured; and a parameter recommendation module for recommending new parameters for use in continuing to manufacture the object.
Clause R. The computer-readable storage medium of clause Q, wherein the volumetric capture module generates the model based on images of the object captured by cameras.
Clause S. The computer-readable storage medium of clause Q or clause S, wherein the defect detection module includes a defect detection machine learning model for detecting defects based on the model.
Clause T. The computer-readable storage medium of any of clauses Q to S, wherein the parameter recommendation module includes a parameter recommendation machine learning model that estimates the new parameters based on the defects.

## Claims

1. A system (900), comprising:
a storage including instructions; and
a processor for executing the instructions, the instructions including:
a defect detection module (920) for:
receiving a model (110) of an object (106) being manufactured based on a design (102) and using parameters (908);
comparing the design and the model; and
detecting in real time a defect (922) in the object being manufactured; and
a parameter recommendation module (926) for recommending an adjustment (925) to the parameters to reduce the defect.

2. The system of claim 1, wherein the instructions further include:
a volumetric capture module for:
receiving images of the object being manufactured; and
generating the model based on the images.

3. The system of claim 2, further comprising:
cameras for capturing the images of the object being manufactured.

4. The system of claim 3, wherein the cameras are positioned to capture the images of the object from multiple different angles.

5. The system of any preceding claim, wherein the parameter recommendation module includes a parameter recommendation machine learning model.

6. The system of any preceding claim, wherein the defect detection module includes a defect detection machine learning model for detecting defects based on the model.

7. The system of any preceding claim, wherein the defect detection module uses similarity metrics to compare the design and the model.

8. The system of any preceding claim, further comprising:
a manufacturing machine for:
manufacturing the object based on the design and using the parameters;
receiving the adjustment to the parameters while the object is being manufactured; and
continuing to manufacture the object using the adjustment to the parameters.

9. The system of claim 8, wherein the manufacturing machine is a 3D printer.

10. A computer-implemented method, comprising:
comparing (812) a design and a model of an object being manufactured by a manufacturing machine using a current parameter;
detecting (814) a defect in the object based on comparing the design and the model;
determining (816) a new parameter based on the defect, the new parameter being an adjustment to or a replacement of the current parameter; and
transmitting the new parameter to the manufacturing machine to continue manufacturing the object using the new parameter.

11. The computer-implemented method of claim 10, further comprising:
capturing a volumetric video of the object while the object is being manufactured; and
generating the model based on the volumetric video.

12. The computer-implemented method of claim 10 or claim 11, further comprising:
using a parameter recommendation machine learning model to determine the new parameter.

13. The computer-implemented method of claim 12, further comprising:
training the parameter recommendation machine learning model using training data including sample designs, sample models, sample defects, and sample parameters.

14. The computer-implemented method of claim 12 or claim 13, further comprising:
determining an initial parameter using the parameter recommendation machine learning model based on the design before manufacturing of the object begins.

15. The computer-implemented method of any of claims 10 to 14, wherein the design and the model are compared using similarity metrics.
